# EUROPEAN PATENT SPECIFICATION

(11) **EP 4 298 168 B1**
(45) Date of publication and mention of the grant of the patent: **12.03.2025**
(21) Application number: 22725928.0
(22) Date of filing: 23.02.2022
(51) Int. Cl.: H01B 1/12, C09D 5/24

(54) **CONDUCTING POLYMER COMPOSITES CONTAINING IRON OXIDE/HYDROXIDE AND THEIR PREPARATION USING FERRATE SALTS**
LEITFÄHIGE POLYMERVERBUNDSTOFFE MIT EISENOXID/HYDROXID UND IHRE HERSTELLUNG UNTER VERWENDUNG VON FERRATSALZEN
COMPOSITES DE POLYMÈRE CONDUCTEUR CONTENANT DE L'OXYDE/HYDROXYDE DE FER ET LEUR PRÉPARATION À L'AIDE DE SELS DE FERRATE

(30) Priority: 26.02.2021 HU 2100074; 21.02.2022 HU 2200046
(43) Date of publication of application: 03.01.2024
(73) Proprietor: Eötvös Loránd Tudományegyetem, 1053 Budapest (HU)
(72) Inventor: LÁNG, Gyözô, 1238 Budapest (HU); SZEKERES, Krisztina, 2760 Nagykáta (HU)
(74) Representative: Szentpéteri, Zsolt
(86) International application number: PCT/HU2022/050014
(87) International publication number: WO 2022/180414

(56) References cited:
- US-A- 5 264 157
- ZHANG ET AL: "Electrochemical deposition and photovoltaic properties of Nano-Fe"2O"3-incorporated polypyrrole films", SYNTHETIC METALS, ELSEVIER SEQUOIA LAUSANNE, CH, vol. 84, no. 1-3, 1 January 1997 (1997-01-01), pages 165 - 166, XP005261098, ISSN: 0379-6779, DOI: 10.1016/S0379-6779(97)80695-9
- JARJAYES O. ET AL: "New nanocomposites of polypyrrole including [gamma]-Fe2O3 particles: electrical and magnetic characterizations", SYNTHETIC METALS, vol. 69, no. 1-3, 1 March 1995 (1995-03-01), CH, pages 343 - 344, XP055946655, ISSN: 0379-6779, DOI: 10.1016/0379-6779(94)02477-G
- JANÁKY CSABA ET AL: "Visible-Light-Enhanced Electrocatalytic Activity of a Polypyrrole/Magnetite Hybrid Electrode toward the Reduction of Dissolved Dioxygen", THE JOURNAL OF PHYSICAL CHEMISTRY C, vol. 114, no. 45, 18 November 2010 (2010-11-18), US, pages 19338 - 19344, XP055946688, ISSN: 1932-7447, DOI: 10.1021/jp105338f
- JARJANES O ET AL: "New nanocomposites from polypyrrole including /spl gamma/-Fe/sub 2/O/sub 3/ particles: morphological and magnetic characterizations", 19940724; 19940724 - 19940729, 24 July 1994 (1994-07-24), pages 325 - 325, XP010580153
- BIDAN G ET AL: "NEW NANOCOMPOSITES BASED ON "TAILOR DRESSED" MAGNETIC PARTICLES IN A POLYPYRROLE MATRIX", ADVANCED MATERIALS, VCH PUBLISHERS, DE, vol. 6, no. 2, 1 February 1994 (1994-02-01), pages 152 - 155, XP000423053, ISSN: 0935-9648, DOI: 10.1002/ADMA.19940060213
- RANDRIAMAHAZAKA H ET AL: "Composite films of iron(III) hexacyanoferrate and poly(3,4-ethylenedioxythiophene): electrosynthesis and properties", JOURNAL OF ELECTROANALYTICAL CHEMISTRY AND INTERFACIAL ELECTROCHEMISTRY, ELSEVIER, AMSTERDAM, NL, vol. 489, no. 1-2, 28 July 2000 (2000-07-28), pages 46 - 54, XP002283834, ISSN: 0022-0728, DOI: 10.1016/S0022-0728(00)00195-9
- QIN RUNHUA ET AL: "Acid-Assisted One-Step In-Situ Polymerization Synthesis of PANI/[alpha]-FeO/[beta]-FeOOH Composites and Its Formation Mechanism", JOURNAL OF INORGANIC AND ORGANOMETALLIC POLYMERS AND MATERIALS, SPRINGER US, NEW YORK, vol. 30, no. 11, 14 July 2020 (2020-07-14), pages 4452 - 4458, XP037268416, ISSN: 1574-1443, [retrieved on 20200714], DOI: 10.1007/S10904-020-01666-8

## Description

### Subiect matter of the invention

The present invention relates to iron oxide/hydroxide-containing conducting polymer composites and processes for their preparation by electrochemical methods using ferrate salts.

### Background

The use of composites comprising electrically conducting polymers with metal-containing (specifically, metal oxide-containing) nanoparticles is widespread in the fields of electrocatalysis, sensors (such as in electronic, electrochromic or optical sensors), and microelectronics.

Various methods are known for producing the above composites, of which electrochemical ones deserve special attention from a practical perspective, due to their low cost and efficiency. In these electrochemical processes, the conducting polymer layer can be prepared on the surface of the substrate directly from the solution containing its monomers.

Among conducting polymers, e.g., poly(3,4-ethylenedioxythiophene) (PEDOT) or poly(3,4-ethylenedioxypyrrole) (PEDOP) are suitable for the electrochemical production of composites containing MnO₂ or WO₃ [Liu R, Duay J, Lee SB (2010) Redox exchange induced MnO2 nanoparticle enrichment in poly (3,4-ethylenedioxythiophene) nanowires for electrochemical energy storage. ACS Nano 4 (2010) 4299-4307., D.V. Zhuzhelskii, E.G. Tolstopjatova, A.I. Volkov, S.N. Eliseeva, G.G. Láng, V.V. Kondratiev, Insights on the electrodeposition mechanism of tungsten oxide into conducting polymers: Potentiostatic vs. potentiodynamic deposition, Synthetic Metals 267 (2020) 116469, A.O. Nizhegorodova, S.N. Eliseeva, E.G. Tolstopjatova, G.G. Láng, D. Zalka, M. Ujvári, V.V. Kondratiev, EQCM study of redox properties of PEDOT/MnO2 composite films in aqueous electrolytes, Journal of Solid State Electrochemistry 22 (2018) 2357-2366.]. In the above publications, the deposition was performed in acidic or neutral solutions since the electrochemical properties of PEDOT and PEDOP conducting polymers are more favorable in acidic media. Additionally, PEDOT and especially PEDOP films, deposited on substrates, are not sufficiently stable in alkaline medium.

Among metal oxide nanoparticles, iron oxide, especially magnetic magnetite (Fe₃O₄)-containing conducting polymers are of particular interest for practical applications. They can be used as contrast agents in magnetic resonance imaging (MRI), and in magnetic recording media, biomolecule separation, heterogeneous catalysis, environmental and food analyzes, as well as immunoassays. Hence, only a few methods are available in the literature for preparing composites. Shin et al. has disclosed a process (S. Shin, J. Jang, Chemical Communications 41 (2007) 4230; S. Shin, H. Yoon, J. Jang, Catalysis Communications 10 (2008) 178), in which the monomer (specifically, 3,4-ethylenedioxythiophene, EDOT) of the conducting polymer reacts with Fe₃O₄ in the presence of a strong acid (HCl). The resulting polymeric material (Fe₃O₄-PEDOT) is used for the adsorption of heavy metal ions and the photocatalytic decomposition of organic dyes. The disadvantages of this method are that the strong acid decomposes the nanostructured magnetic clusters, and the magnetic nanoparticles dissolve in HCl and form water-soluble Fe³⁺/Fe²⁺ ions, which leads to a decrease in the magnetite content. It is worth to note that no other iron oxide/hydroxide compounds form in strongly acidic medium; therefore, the solution contains solely the chloride salt of the above-mentioned iron ions.

In the process developed by Reddy et al. (K. R. Reddy, W. Park, B. C. Sin, J. Noh, and Y. Lee, Journal of Colloid and Interface Science, vol. 335, no. 1, pp. 34-39, 2009), a dispersed core-shell type composite is prepared by the in situ polymerization of an EDOT monomer in the presence of magnetic nanoparticles (Fe₃O₄) in the micellar solution of lignosulfonic acid. It is noted that the diffraction pattern of magnetite (Fe₃O₄) does not contain any indication of impurities, i.e., the material is considered to be pure.

Zheng et al. (M. Zheng, J. Huo, Y. Tu, J. Jia, J. Wu, and Z. Lan, RSC Advances, vol. 6, no. 2, pp. 1637-1643, 2016.) deposited a solution of EDOT precursor doped with Fe₃O₄ on fluorine-doped tin oxide (FTO) glass via spin-coating to form a PEDOT/Fe₃O₄ film with polymerization reaction. The technology requires many steps of preparation, moreover, it takes a long time, and less cost-effective. The produced film is used as a counter electrode in dye-sensitized solar cells (DSSC).

There are also reports in the literature for the preparation of core-shell composites containing γ-Fe₂O₃ and polyaniline or polypyrrole [R. Gangopadhyay A. De, Conducting Polymer Nanocomposites: A Brief Overview, Chemistry of Materials 12 (2000) 608-622.].

An important circumstance is that in the fabrication of core-shell systems, the polymer is deposited on the surface of the preformed magnetite or hematite nanoparticles. Thus, the "composite" actually consists of a set of tiny spherical units and the polymer does not form a coherent matrix. This attribution of the composite is disadvantageous in terms of mechanical stability, and such aggregate-like composites are obviously not suitable for applications, in which they might be subjected to severe mechanical deformation.

Qin et al., (Journal of Inorganic and Organometallic Polymers and Materials, published online: July 14, 2020; https://doi.org/10.1007/s10904-020-01666-8; title: Acid - Assisted One - Step In - Situ Polymerization Synthesis of PANI /α-Fe2O3/β-FeOOH Composites and Its Formation Mechanism) presented polyaniline (PANI)-based composites, during preparation of which, iron oxide/hydroxide-containing composites form, where the polymerization is carried out in the presence of FeCl₃, therefore, the final polymer contains FeCl₃ among its chains. The final step of the process is the powder grinding of the resulting solid material. A similar procedure was applied by Prasanna et al. (Synthesis of polyaniline/alfa-Fe2O3 nanocomposite electrode material for supercapacitor applications; Materials Today Communications (2017), vol 12, 72-78) to prepare PANI/FeCl₃ composite (in this case, a powdery material was obtained).

None of the methods described for the production of composites, containing iron oxide/hydroxide compounds embedded in a conducting polymer matrix, are electrochemical processes. Additionally, in the known methods, magnetite (Fe₃O₄) particles or in the case of PANI, Fe₂O₃/FeOOH particles are incorporated into the systems during the polymerization steps, not following the formation of the polymer films.

### Detailed description of the invention

The present invention provides a simple, cost-effective, and reproducible electrochemical process for the preparation of iron oxide/hydroxide-containing conducting polymer composites. The conducting polymer can be e.g. poly(3,4-ethylenedioxythiophene) (PEDOT), polyaniline (PANI), poly(ortho-phenylenediamine) (PoPD), preferably poly(3,4-ethylenedioxythiophene) (PEDOT) or polyaniline (PANI) or other polymers of similar structure.

In an embodiment of the invention, the preferred conducting polymer is poly(3,4-ethylenedioxythiophene) that is PEDOT, which is a conducting polymer with good electrical conductivity, well-controllable optoelectronic and redox properties. The alkylenedioxy substituent on the polythiophene backbone serves to improve electrochemical, optical, and electrochromic properties. PEDOT is a widely employed conducting polymer because of its stability and reproducibility. It is found in TNT sensors, hydrogen chloride and ammonia vapor detectors, NO₂ sensors, neural probes, uric acid and dopamine sensors, and other medical sensors. In case of PEDOT, the alkylenedioxy substituent on the polythiophene backbone is an ethylenedioxy group. In principle, it is also possible to use similar polymers with a *β*-polythiophene backbone, wherein the optionally substituted alkylenedioxy substituent contains greater number of carbon atoms, for example 3-12, preferably 3-8 carbon atoms. Such thiophene-based monomers are presented in the literate: a) J-H Kang et al.: A Dual-Polymer Electrochromic Device with High Coloration Efficiency and Fast Response Time: Poly(3,4-(1,4-butylene-(2-ene)dioxy)thiophene)- Polyaniline ECD, Chem. Asian J., 2011, 6, 2123-2129; and b) L. A. Estrada: "Direct (Hetero)arylation Polymerization: An Effective Route to 3,4-Propylenedioxythiophene-Based Polymers with Low Residual Metal Content", dx.doi.org/10.102/mz4003886 I ACS Macro Lett. 2013, 2, 869-873). That is, starting materials can also be polymers with a polythiophene backbone, wherein thiophene monomers are substituted with 2-12 carbon atom-containing alkylenedioxy groups, which are optionally substituted. The preferred ones are those substituted with 2-8 carbon atom-containing alkylenedioxy groups, especially those substituted with 2 or 3 carbon atom-containing alkylenedioxy group, within PEDOT is considered to be the most preferred.

The normal oxidation/reduction of PEDOT is as follows:

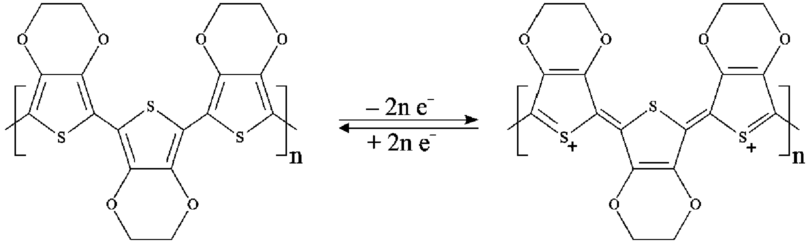

In an embodiment of the invention, it is preferred to reinforce the layers of the above polymers with non-conducting polymers (e.g., polyphenols [preferably poly(bisphenol-A) - PBPA], and polyalkenes). Films, reinforced with non-conducting polymers, are more resistant to degradation as a consequence of overoxidation that may occur during the process. That is, the reinforcement is "mechanical" in nature (thus referred to as "mechanical reinforcement", as well) because the reinforcing polymer "fixes" the oxidized conducting polymer layers that tend to delaminate from the substrate. In addition, it protects the conducting polymer layer as a non-enclosed cover layer/cloud (e.g., essentially against UV radiation) but does not completely close it from the environment, allowing the conducting polymer to contact with the medium surrounding it.

Overoxidation is defined as the partial irreversible oxidation of the polymer at the applied positive potentials, which can lead to a considerable change in the structure or the degradation of the polymer film [G.G. Láng, M. Ujvári, S. Vesztergom, V. Kondratiev, J. Gubicza, K.J. Szekeres: The Electrochemical Degradation of Poly(3,4-ethylenedioxythiophene) Films Electrodeposited from Aqueous Solutions, Z. Phys. Chem. 2016 (230) 1281-1302.]. Causing this phenomenon by cyclic voltammetric method, we found that an oxidation peak appears at sufficiently positive potentials, where the polymer film is overoxidized, and there is no corresponding reduction peak at more negative potentials.

The moderate overoxidation can also be beneficial for the formation of the composite, as it increases the porosity of the film (which is also advantageous, for example, when used in sensors); while strong overoxidation leads to polymer degradation, separation of polymer chains, and delamination from the substrate. Reinforcement with non-conducting polymers also prevents the separation of the polymer chains and the delamination of the film. Irreversible deposition of PBPA on the surface of PEDOT films has been observed previously [E. Mazzotta, C. Malitesta, E. Margapoti, Direct electrochemical detection of bisphenol A at PEDOT-modified glassy carbon electrodes, Anal. Bioanal. Chem. 405 (2013) 3587-3592.], however, it was considered to be a detrimental phenomenon because of the passivation of electrodes, that is, its advantages of the process according to the invention were not recognized. Based on passivation, it is assumed that an even more closed (more "covering") layer of PBPA was deposited in this study, than described in the present invention.

An essential feature of the process according to the invention is that the incorporation of iron oxides/iron hydroxides into the electrodeposited conducting polymer films on inert substrates (gold, platinum, graphite, glassy carbon, conducting carbon layers, and carbon fibers) is effected via reducing ferrate ions (FeO₄²⁻). That is, the production of conducting polymer layer and the incorporation of iron oxide and iron hydroxide compounds [including FeO(OH)] into it are spatially and temporarily separated processes. Thus, the conducting polymer layer can form under ideal conditions (i.e., only in the presence of the necessary reagents), which improves its quality.

As used herein, the term iron oxide means any of Fe(II) oxide (FeO), Fe(III) oxide (Fe₂O₃), and Fe₃O₄ (magnetite) containing both Fe(II) and Fe(III) atoms or a mixture of them in any ratio. The term iron hydroxide means any of Fe(II) hydroxide [Fe(OH)₂] and Fe(III) hydroxide [Fe(OH)₃] or a mixture of them in any ratio. The composite can contain a mixed oxide-hydroxide compound [FeO(OH)], too.

As used herein, the term iron oxide/hydroxide refers to an iron-containing material comprising one or more compounds selected from: Fe₂O₃, Fe₃O₄, Fe(OH)₂, Fe(OH)₃, and FeO(OH). In preferred embodiments, the term iron oxide/hydroxide refers to an iron-containing material, which includes essentially one or more compounds selected from: Fe₂O₃, Fe₃O₄, Fe(OH)₂, Fe(OH)₃, and FeO(OH), and optionally, consists only of these listed.

The ratio of iron oxide to iron hydroxide compounds incorporated into the film (including FeO(OH) compound) can be modified by the electrochemical reduction and oxidation of the composite. Therefore, it is possible to achieve a composition, in which typically Fe(III) or typically Fe(II) compounds are present in the vast majority, or magnetite (Fe₃O₄) - a compound containing the mixture of Fe(II) and Fe(III) ions - dominate. In theory, the production process according to the invention is suitable for the synthesis of a composite comprising pure magnetite and a composite free of magnetite, as well. However, applying the electrochemical production method according to the invention in practice, however, other Fe(II) and Fe(III) compounds form in the composite in addition to magnetite. Such composites according to the invention differ from those known as prior art (i.e., they are considered novel), as in the known processes, pure magnetite is incorporated into the conducting polymer during the process of producing the polymer [or if other Fe(II) and Fe(III) compounds were incorporated into the polymer (by simple co-polymerization), PANI was the base polymer]. Magnetite is a rather stable compound, it is difficult to dissolve even in strong acids. Therefore, the products of the known processes starting from magnetite, contain other iron oxide/hydroxide compounds only as impurities (i.e., in amounts below 1 wt%, often only in trace amounts). In the composites according to the invention, the amount of iron oxide/hydroxide compounds other than magnetite is up to 100%, but typically at least 1-25 wt%, preferably it is 2-10 wt%, calculated from the total mass of the iron oxide/hydroxide compounds.

The possibility that iron oxide/hydroxide-containing nanoparticles can be introduced into the conducting polymer matrix starting from ferrate ions is unexpected based on previous knowledge, since ferrate ions are stable only in a strongly alkaline medium (pH >> 13, typically 14-15) and they degrade rapidly in neutral or acidic medium. In contrast, electrochemical properties of conducting polymers are considerably worse in an alkaline medium, they are easily degraded (e.g., polymer films deposited on a support can easily delaminate). In addition, ferrate ions are quite strong oxidizing agents in neutral and mild alkaline media, therefore they can oxidize and degrade the polymer chains. It is assumed, that for these reasons, ferrate ions have not been used for the incorporation of iron oxide/hydroxide compounds into conducting polymers before. In our experiments, however, we have found that there is a pH range (7-13, preferably 9-12) - that is not obvious to a person skilled in the art - wherein the above negative phenomena has only a minor extent, which makes the use of ferrate ions possible for the incorporation of iron oxide/hydroxide compounds into the conducting polymer. That is, under these conditions, a part of conducting polymers (preferably PEDOT, polyaniline) is still sufficiently stable and electroactive, while the decomposition of ferrate ions occurs slowly enough to allow them to enter the polymer.

The non-obvious nature of the present invention is further confirmed by the fact that applying the known and widely used poly(3,4-ethylenedioxypyrrole) (PEDOP) conducting polymer, it was impossible to prepare iron oxide/hydroxide-containing composites by the methods described in this description, because, in contact with the medium (alkaline solution, containing ferrate ions) the polymer has become unusable (degraded).

### Preparation of iron oxide/hydroxide-containing conducting polymer composites

In a preferred embodiment of the invention, the conducting polymer layer was formed by galvanostatic polymerization (as described in Examples 1-7) or potentiodynamic deposition (as described in Example 8) on the surface of the substrate.

During galvanostatic deposition, the current between the working electrode and the counter electrode is kept constant, while the potential difference between the working electrode and the reference electrode is monitored in the cell as a function of time.

In potentiodynamic deposition [cyclic voltammetry or (dynamic) cyclization of the electrode potential, or simply potentiodynamic cyclization], the potential of the working electrode is periodically varied according to a suitably selected triangular signal while measuring the current flowing through the cell. The advantage of this method is that the amplitude and frequency of the periodic potential perturbation can be chosen according to the properties of the system. This method can be applied to incorporate iron into the conducting polymer, as well, see further details below.

During the deposition process of conducting polymer, the current density (*j*) is typically 0.05-1.00 mA/cm², preferably 0.1-0.3 mA/cm², for example 0.2 mA/cm². The reaction time is typically 500-15000 s, preferably 1000-8000 s, for example 1800 s or 3600 s. The pH of the solution is approx. neutral (e.g., pH = 5-8), and the reaction was preferably carried out at room temperature (*T* = 20-25 °C).

For the formation of iron oxide/hydroxide-containing conducting polymers - i.e., for the incorporation of iron into the film - two types of electrochemical processes were applied:
1. The reduction of ferrate ions inside the polymer that is in its reduced state takes place by the "reaction" of polymer chains and ferrate ions. Therefore, we work in an electrode potential range where the polymer is in a reduced state, which can preferably be adjusted by using a potentiostat. The appropriate potential range depends on the quality of the polymer and the reference electrode. The determination of the appropriate electrode potential belongs to the knowledge of the person skilled in the art. The applied potential in neutral medium (pH = 5-7) typically falls in the range of (-0.45)-(+0.05) V, preferably (-0.35)-(-0.05) V [measured against saturated sodium chloride filled calomel electrode (SSCE)]. It is important to note that the polymer has to be in a reduced state.

The reduction of ferrate ions takes place according to the following chemical reaction equations. In these equations, (P)⁻ means the negatively charged section of the polymer chain, i.e., the "active site," (P) is the active site in the neutral state, and (P)⁺ indicates the oxidized state of the active site. To stabilize ferrate ions, reduction is performed under alkaline conditions, preferably in the range of pH = 10-14.

2 FeO₄²⁻ + 10 H₃O⁺ + 6 (P)⁻ = Fe₂O₃ + 15 H₂O+ 6 (P)

3 FeO₄²⁻ + 16 H₃O⁺ + 10 (P)⁻ = Fe₃O₄ + 24 H₂O+ 10 (P)

2 FeO₄²⁻ + 10 H₃O⁺ + 3 (P)⁻ = Fe₂O₃ + 15 H₂O+ 3 (P)⁺

3 FeO₄²⁻ + 16 H₃O⁺ + 5 (P)⁻ = Fe₃O₄ + 24 H₂O+ 5 (P)⁺

FeO₄²⁻ + 5 H₃O⁺ + 3 (P)⁻ = Fe(OH)₃ + 6 H₂O+ 3 (P)

FeO₄²⁻ + 5 H₃O⁺ + 3 (P)⁻ = FeO(OH) + 7 H₂O+ 3 (P)

Based on the above, redox reactions (electron transfer) occur among the active sites of the polymer chains and ferrate ions. The state of the polymer film can be controlled by adjusting the electrode potential to an appropriate range (which can preferably be modified with a potentiostat). The reduced state-film has to be removed from the cell used to perform the electrochemical reduction, and immersed in a solution containing ferrate ions (thus contacting the film with ferrate ions). This way, reactions can occur among active sites and ferrate ions. By repeating the reduction and immersion steps, the amount of iron oxide/hydroxide incorporated into the film can be gradually increased.

According to another production process, reduction takes place in a ferrate-containing solution, followed by soaking the formed material in the solution (relaxation) for 15-300 s, preferably 30-60 s (it is also a kind of implementation of the "contacting" discussed above). The iron content is increased by adding further ferrate solution and/or by repeating steps (i.e., by repeating the reduction and then the soaking step for several times).

Moreover, moderate overoxidation of the conducting polymer film can enhance the increase of the incorporating iron oxide/hydroxide content because cracks appear in the structure of the polymer (i.e., its porosity increases). Moderate overoxidation means that the conducting polymer is subjected to oxidation, which is strong enough to cause the conducting polymer to partially oxidize irreversibly. [In this case, the value of the electrode potential (positive potential limit in the case of cyclization) has to be (+0.8)-(+1.2) V vs. SSCE, preferably (+0.9)-(+1.1) V vs. SSCE in neutral medium (pH = 5-7)].

2. At sufficiently positive electrode potentials [which can preferably be adjusted by using a potentiostat, the appropriate potential range depends on the quality of the polymer and the reference electrode; the determination of the appropriate electrode potential belongs to the knowledge of the person skilled in the art; it is important that the polymer has to be in its oxidized state, that is, positively charged sites develop on the chains], the ferrate ions, that are negatively charged counterions (as a negative ion, it compensates the positive charges developed at positive potential in the polymer film), enter the film immersed in the solution containing ferrate ions. Then, changing the electrode potential in negative direction, the (parallel) reduction of polymer chains and ferrate ions occur, typically accompanied by the transport of positive ions (e.g., H₃O⁺) and solvent. The applied potential window in alkaline medium (pH = 10-12) is *E* = (-0.7)-(+0.4) V vs. SCE, preferably *E* = -0.4-(+0.3) V vs. SCE (potassium chloride saturated calomel electrode). According to the above, by changing the electrode potential in the negative direction, ferrate ions entering the film as counterions, are involved in the following reduction processes, for example:

2 FeO₄²⁻ + 10 H₃O⁺ + 6 e⁻ = Fe₂O₃ + 15 H₂O

3 FeO₄²⁻ + 16 H₃O⁺ + 10 e⁻ = Fe₃O₄ + 24 H₂O

FeO₄²⁻ + 5 H₃O⁺ + 3 e⁻ = Fe(OH)₃ + 6 H₂O

FeO₄²⁻ + 5 H₃O⁺ + 3 e⁻ = FeO(OH) + 7 H₂O

Thus, the iron oxide/hydroxide compounds form by the direct electrochemical reduction of ferrate ions.

By repeating the oxidation and reduction steps, the amount of iron oxide/hydroxide incorporated into the film can be gradually increased. The repetition of the oxidation and reduction steps can be performed by cyclic voltammetry (also known as potentiodynamic cyclization).

The electrochemically active iron oxide/hydroxide compounds - incorporated as nanoparticles into the composite electrode - can be converted into each other by varying the electrode potential, according to the following reaction equations (this is of course true for the final product of both of the above processes), for instance:

3 Fe₂O₃ + 2 H₃O⁺ + 2 e⁻ = 2 Fe₃O₄ + 3 H₂O

3 Fe(OH)₃ + H₃O⁺ + e⁻ = Fe₃O₄ + 6 H₂O

3 FeO(OH) + H₃O⁺ + e⁻ = Fe₃O₄ +3 H₂O

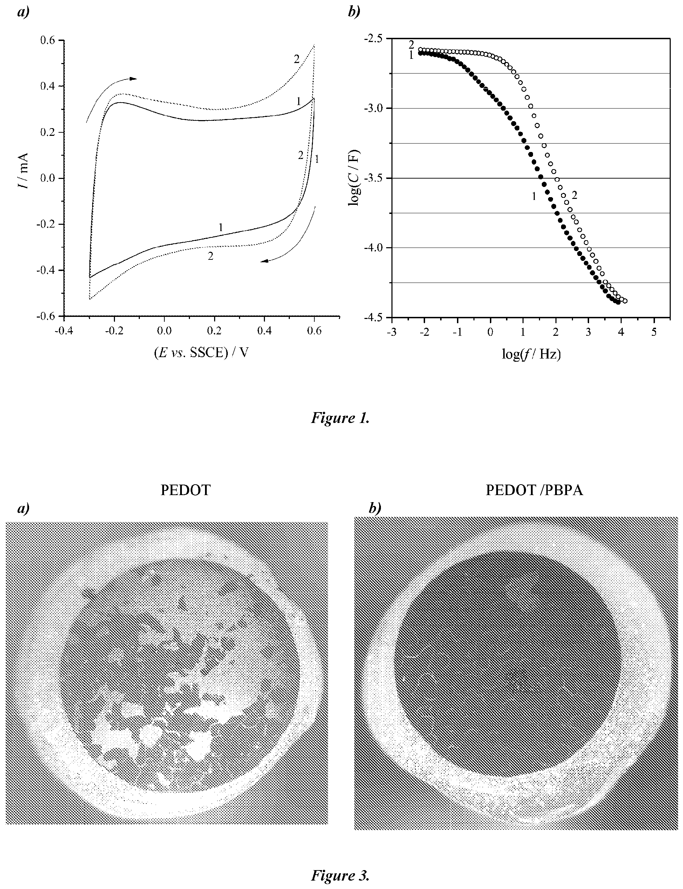

Using both types of processes, it was observed that ferrate treatment - i.e., the incorporation of iron oxide/hydroxide particles into the polymer films - considerably improved the electrochemical properties of the polymer films. From a practical point of view, it might be especially interesting that the frequency-dependent capacity of the films has increased in the range of medium frequencies (see **Figure 1 b)**). This also means that films can respond faster to sudden potential changes, making them more suitable for applications in devices with supercapacitors (e.g., transient energy storage).

### BRIEF DESCRIPTION OF THE FIGURES

**Figure 1 a)** shows cyclic voltammograms (curves are recorded during the third cycle, *E* = (-0.3)-(+0.6) V vs. SSCE, *v* = 100 mV/s); **Fig 1 b)** shows the logarithm of the (frequency-dependent) capacitance values (*Y"*/*ω*) calculated from the impedance spectrum (*E* = 0.1 V vs. SSCE) as a function of the logarithm of the frequency. Measurements were carried out in 0.1 M Na₂SO₄ electrolyte solution, (1) indicates a PEDOT film that was deposited on a gold (*A* = 0.196 cm²) substrate, and prepared according to Example 3, and (2) indicates a PEDOT|iron oxide/hydroxide layer.

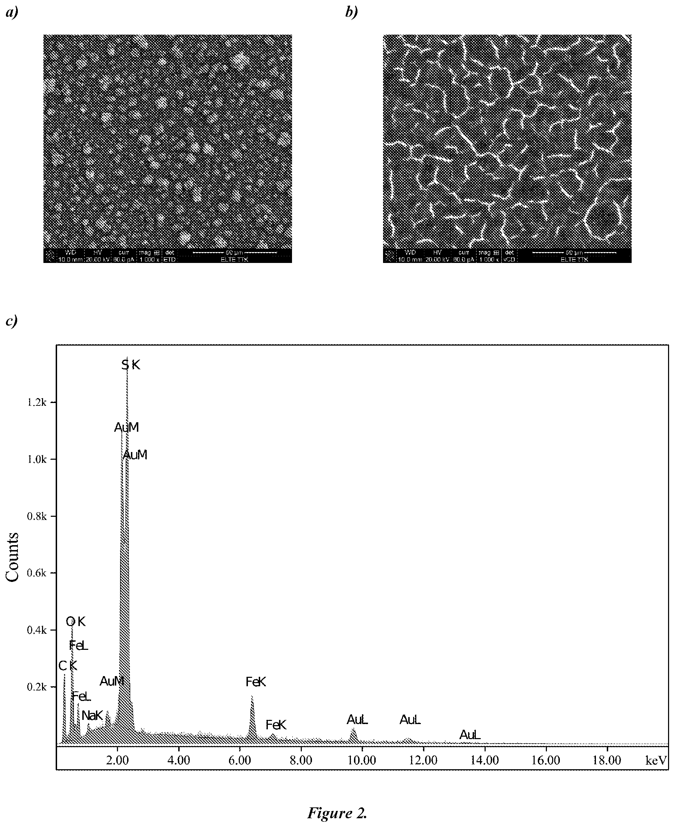

**Figure 2 a) and b)** shows SEM images of a PEDOT|iron oxide/hydroxide composite layer deposited on a gold substrate according to Example 1 (Table 1 # 1) with a) secondary electrons b) backscattered electrons. The scales at the bottom of the images correspond to 50 µm. **Figure 2 c)** shows an EDX spectrum that demonstrates the atomic composition of the sample, and the peaks corresponding to iron are indicated as well.
**Figure 3** shows the increased resistance of the PBPA-reinforced PEDOT layer to overoxidation compared to the bisphenol A-untreated PEDOT film. PEDOT **(****Fig 3 a**)) and PEDOT/PBPA **(****Fig. 3 b)**) samples were deposited on a gold substrate according to Example 7. Photographs of the layers after strong overoxidation show a good structure-reinforcing effect of PBPA.

### EXAMPLES

All electrochemical measurements were performed at room temperature (22.0 ± 0.5) °C. Solutions were saturated with oxygen free argon gas (Linde 5.0) before use, and the inert gas atmosphere was maintained during the experiments. Electrochemical measurements were performed with a Zahner IM6 electrochemical workstation controlled by a Thales software. Scanning electron microscopic (SEM) images were taken with a Quanta^{™} 3D FEG high-resolution dual-beam scanning electron microscope (SEM/FIB). Both secondary and scattered electrons were detected during scanning.

### Investigation of the PEDOT layer

The electrochemical investigation of the PEDOT layer was carried out in a three-electrode cell, which has a volume of 150 cm³, and the working electrode was a PEDOT layer, deposited on a gold disk (*A* = 0.196 cm²), the reference electrode was a sodium chloride saturated calomel electrode (SSCE), and the counter electrode was a ring-shaped platinum plate. These electrodes were immersed in a 0.1 mol / dm³ H₂SO₄ solution. The potential window used in cyclic voltammetric studies was *E =* (-0.1)-(+0.8) V vs. SSCE, scan rates were v = 100 and 50 mV/s. Electrochemical impedance spectroscopic (EIS) measurements were performed in the frequency range of 50 kHz to 96.1 mHz, the perturbation signal amplitude was 5 mV, and the electrode potential was *E* = (+0.4) V or (+0.2) V vs. SSCE.

### I. Synthesis of PEDOT layer-containing composites

### Example 1

(1) The electrochemical deposition of PEDOT layer was carried out in a three-electrode cell, which has a volume of 150 cm³. The deposition was performed on a gold substrate (*A* = 0.196 cm²) under galvanostatic conditions (*j* = 0.2 mA/cm², *t* = 3600 *s*)*.* The composition of the monomer-containing solution was: 0.01 M EDOT / 0.1 M Na₂SO₄ (pH = 6). The counter electrode was a ring-shaped platinum plate. A potassium chloride saturated calomel electrode (SCE) was used as a reference electrode.
(2) The reduction of the deposited PEDOT layer was carried out in a 0.1 M Na₂SO₄ (pH = 5) solution (*E* = -0.3 V, *t* = 120 s). A sodium chloride saturated calomel electrode (SSCE) was used as a reference electrode.
(3) The reduced PEDOT layer was immersed in a 0.05 M Na₂FeO₄/NaOH solution (*t =* 30 s; pH = 14-10*).
(4) Steps (2) and (3) were repeated 10 times consecutively.

*: The pH is decreasing during the process.

The following examples were carried out basically as described in Example 1, therefore, only the main characteristics will be given of the processes.

### Example 2:

(1) Electrochemical deposition of PEDOT layer on gold substrate, under galvanostatic conditions (*j* = 0.2 mA/cm², *t* = 3600 s) from 0.01 M EDOT/0.1 M Na₂SO₄ electrolyte (counter electrode: Pt, reference electrode: SCE).
(2) The reduction of the deposited PEDOT layer in a 0.1 M Na₂SO₄ (pH = 5) solution (*E* = - 0.3-(+1.1) V vs. SSCE; *v* = 50 mV/s, 3 cycles). In case of the applied positive potential limit, the polymer partly oxidizes irreversibly (overoxidation), therefore the structure becomes more porous, facilitating the entry of ions into the polymer film.
(3) The reduction of the deposited PEDOT layer was carried out in a 0.1 M Na₂SO₄ (pH = 5) solution
   (*E* = -0.3 V *vs.* SSCE; *t* = 120 s).
(4) The reduced PEDOT layer was immersed in a 0.05 M Na₂FeO₄/NaOH solution (pH = 14-10*, *t =* 30 s).
(5) Steps (3) and (4) were repeated 10 times consecutively.
*: The pH is decreasing during the process.

### Example 3:

(1) Electrochemical deposition of PEDOT layer on gold substrate, under galvanostatic conditions (*j* = 0.2 mA/cm², *t* = 3600 s) from 0.01 M EDOT/0.1 M Na₂SO₄ electrolyte (counter electrode: Pt, reference electrode: SCE).
(2) The reduction of the deposited PEDOT layer in a 0.1 M Na₂SO₄ (pH = 5) solution (*E =* -0.3 V *vs.* SSCE; *t =* 300 s).
(3) The reduced PEDOT layer was immersed in a 0.05 M Na₂FeO₄/NaOH solution (pH = 14-10*,t = 300 s).
*: The pH is decreasing during the process.

### Example 4:

(1) Electrochemical deposition of PEDOT layer on gold substrate, under galvanostatic conditions (*j* = 0.2 mA/cm², *t* = 3600 s) from 0.01 M EDOT/0.1 M Na₂SO₄ electrolyte (counter electrode: Pt, reference electrode: SCE).
(2) The reduction of the deposited PEDOT layer in a 0.05 M Na₂FeO₄/NaOH (pH = 14*) solution
   (*E* = -0.56 V *vs.* SSCE; *t* = 300 s).
Immersion of the reduced PEDOT layer in the solution of step (2) (*t* = 300 s).
*: The pH is decreasing during the process.

### Example 5:

(1) Electrochemical deposition of PEDOT layer on gold substrate, under galvanostatic conditions (*j* = 0.2 mA/cm², *t* = 1000 s) from 0.01 M EDOT/0.1 M Na₂SO₄ electrolyte (counter electrode: Pt, reference electrode: SCE).
(2) The reduction of the deposited PEDOT layer in a 0.1 M Na₂SO₄ (pH = 5) solution (*E* = -0,3 V *vs.* SSCE; *t* = 120 s).
(3) The reduced PEDOT layer was immersed in a 0.05 M Na₂FeO₄/NaOH solution (pH = 14-10*, *t =* 30 s).
(4) Steps (2) and (3) were repeated 10 times consecutively.
*: The pH is decreasing during the process.

### Example 6:

(1) The electrochemical deposition of PEDOT layer was carried out in a three-electrode cell, which has a volume of 150 cm³. The deposition was performed on a gold substrate (*A* = 0.196 cm²) under galvanostatic conditions (*j* = 0.2 mA/cm², *t* = 3600 s). The composition of the monomer-containing solution was: 0.01 M EDOT / 0.1 M Na₂SO₄ (pH = 5). The counter electrode was a ring-shaped platinum plate. A potassium chloride saturated calomel electrode (SCE) was used as a reference electrode.
(2) The reduction of the deposited PEDOT layer was carried out in a 0.1 M Na₂SO₄ (pH = 5) solution (*E* = -0.3 V, *t* = 120 s). A sodium chloride saturated calomel electrode (SSCE) was used as a reference electrode.
(3) The reduced PEDOT layer was immersed in a 0.05 M Fe₂FeO₄/KOH solution (*t* = 30 s; pH = 14-10*).
(4) Steps (2) and (3) were repeated 10 times consecutively.
*: The pH is decreasing during the process.

### Example 7:

(1) Electrochemical deposition of PEDOT film on gold substrate, under galvanostatic conditions (*j* = 0.2 mA/cm², *t* = 3600 s) from 0.01 M EDOT/0.1 M Na₂SO₄ electrolyte (pH = 5, counter electrode: Pt, reference electrode: SCE).
(2) The reduction of the deposited PEDOT layer in a 0.1 M Na₂SO₄ (pH = 5) solution
   (*E* = -0.3 V *vs.* SSCE; *t =* 300 s).
(3) The immersion of the reduced polymer layer into 0.05 M Na₂FeO₄ / NaOH solution and its cyclic potentiodynamic polarization: 21 cycles (pH = 14-10*, *E* = (-0.4) -(+0.3 V) vs. SCE; *v* = 100 mV/s.)
*: The pH is decreasing during the process.

### Example 8:

(1) Electrochemical deposition of PEDOT layer on gold substrate, under galvanostatic conditions (*j* = 0.2 mA/cm², *t* = 3600 s) from 0.01 M EDOT/0.1 M Na₂SO₄ electrolyte (counter electrode: Pt, reference electrode: SCE).
(2) The immersion of PEDOT layer into 0.05 M K₂FeO₄/KOH solution, and its cyclic potentiodynamic polarization: 21 cycles (pH = 14-10*, *E* = (-0.4) -(+0.3) V vs. SCE; *v* = 100 mV/s.)
   *: The pH is decreasing during the process.

**Table 1** summarizes the parameters of the production of various PEDOT/FeₓO_{y} composites and their iron content in atomic percent (atom%).

**Table 1: Production parameters of PEDOT/iron oxide/hydroxide composites deposited on a gold substrate (t_{dep}: deposition time of the PEDOT layer, Overox: occurrence of overoxidation of the PEDOT layer, t_{red}: reduction time, E_{red}: reduction potential compared to SSCE electrode, pH_{red}: pH of the reduction medium, t_{imm.}: immersion time, atom% (Fe): data obtained from EDX measurements).**

| # | *t*_{dep} / s | Overox | *t*_{red*.*} / s | *E*_{red.} / V | pH_{red.} | immersion medium | *t*ᵢₘₘ / s | reduction + number of immersions | atom% (Fe) |
|---|---|---|---|---|---|---|---|---|---|
| 1 | 3600 | - | 120 | -0.3 | 5 | 0.05 M FeO₄²⁻ / NaOH | 30 | 10 | 3.14 |
| 2 | 3600 | + | 120 | -0.3 | 5 | | 30 | 10 | 5.40 |
| 3 | 3600 | - | 300 | -0.3 | 5 | | 300 | 1 | 3.39 |
| 4 | 3600 | - | 300 | -0.56 | 14 | | 300 | 1 | 9.15 |
| 5 | 1000 | - | 120 | -0.3 | 5 | pH = 14-10 | 30 | 10 | 2.54 |
| 6 | 3600 | - | 120 | -0.3 | 5 | | 30 | 10 | 7.32 |
| 7 | 3600 | - | 300 | -0.3 | 5 | | * | 1 | 5.84 |
| 8 | 3600 | - | - | - | - | | * | 1 | 10.21 |

| | | | | | | | | | |
|---|---|---|---|---|---|---|---|---|---|
| *potentiodynamic: 21 cycles, *E* = (-0.4) -(+0.3 V) vs. SCE; *v* = 100mV/s | | | | | | | | | |

The content of **Figure 1** is discussed here in more detail: **a)** cyclic voltammograms (curves are recorded in the third cycle, *E* = (-0.3)-(+0.6) V vs. SSCE, *v* = 100 mV/s) and **b)** logarithm of the (frequency-dependent) capacitance values (*Y"*/*ω*) calculated from the impedance spectrum (*E* = 0.1 V vs. SSCE) as a function of the logarithm of the frequency (as a function of the logarithm of the frequency of the perturbing signal) of the PEDOT films (1) deposited on a gold substrate (*A* = 0.196 cm²), prepared according to Example 3, and of the PEDOT/iron oxide/hydroxide layer (2) in 0.1 M Na₂SO₄ electrolyte. Investigating the electrochemical properties of the composite, it is seen that the iron-containing composite also preserved the capacitive property of the original film containing only the conducting polymer **(****Fig. 1 a)**). The low-frequency capacity of the composite layer moderately increased, while there is a definite rise in capacity in the mid-range compared to the pure PEDOT layer without iron oxide/hydroxide **(****Fig. 1 b)**). In practice, this growth in capacity means that the iron content of the polymer layer is electrochemically active, that is, the oxidation state can be tuned by changing the potential. Furthermore, the capacity of the modified polymer film is linear over a wider range, which is a highly advantageous property for its use as a supercapacitor.

The content of Figure 2 is discussed here in more detail: From the PEDOT/iron oxide/hydroxide composite layer deposited on gold support prepared according to Example 1 (Table 1 # 1) a) SEM images recorded with secondary electrons b) backscattered electrons and c) EDX spectra showing the atomic composition of the sample, in which peaks can be seen that correspond to iron. The scales at the bottom of the figures correspond to 50 µm. Electron microscopic images demonstrated that the PEDOT|iron oxide/hydroxide composite films also show the cauliflower-like structures that are characteristic for PEDOT. In the backscattered electron images, the composite (darker details) can be well distinguished from the gold substrate (light details). Based on these, it can be observed that the layer is heavily cracked, not homogeneous, which is probably the effect of the steps used in the synthesis of the composite (overoxidation).

The presence of iron oxides in layers can also be detected by Mössbauer spectrosopy. The composition cannot be given due to the small size of the iron-containing crystals.

### II. Production of a conducting polymer layer reinforced with PBPA layer

### Example 9

### Preparation of PEDOT film reinforced with poly(bisphenol A) [PBPA]

### step 1: Deposition of poly(3,4-ethylenedioxythiophene) layer

The electrochemical deposition of the PEDOT layer was carried out in a three-electrode cell, which has a volume of 150 cm³, in which the working electrode was a gold disk (*A* = 0.196 cm²), the reference electrode was the potassium chloride saturated calomel electrode (SCE), and the counter electrode was a ring-shaped platinum disk. These electrodes were immersed in a 0.01 mol / dm³ EDOT / 0.1 mol / dm³ Na₂SO₄ (pH = 5) as-prepared solution. We applied *j* = 0.2 mA / cm² current density during the galvanostatic deposition. The deposition time was *t* = 1800 s.

The prepared polymer layer was soaked in Milli-Q water for relaxation for one day (thus ensuring the removal of the oligomers).

### step 2: Deposition of poly(bisphenol A) [PBPA] layer

The electrochemical deposition of the PBPA layer on the PEDOT layer was performed with a potentiodynamic method, in a 30 cm³ three-electrode cell, in which the working electrode was the PEDOT layer, deposited on a gold plate (*A* = 0.196 cm²), immersed in a 100 ppm BPA / 0.5 mol/dm³ H₂SO₄ (pH = 0.6) solution; reference electrode was a saturated sodium chloride filled calomel electrode (SSCE); and the counter electrode was a platinum wire. During potentiodynamic deposition, the potential window was *E* = -0.1-(+1.0) V *vs.* SSCE, scanning speed was *v* = 100 mV/s, and the number of cycles was 10.

### step 3: Investigation of the PEDOT/PBPA layer

The electrochemical deposition of the PEDOT layer was carried out in a three-electrode cell, which has a volume of 150 cm³, in which the working electrode was a gold disk (*A* = 0.196 cm²), the reference electrode was potassium chloride saturated calomel electrode (SCE), the counter electrode was a ring-shaped platinum plate. These electrodes were immersed in a 0.1 mol / dm³ EDOT / 0.1 mol / dm³ Na₂SO₄ (pH = 1.3) as-prepared solution. The potential window during the cyclic voltammetric investigations was *E =* (-0.1)-(+0.8) V *vs.* SSCE, scanning speed was *v* = 100, and 50 mV/s. Electrochemical impedance spectroscopic (EIS) measurements were performed in the frequency range of 50 kHz-96.1 mHz, the perturbation signal amplitude was 5 mV, and the electrode potential was *E* = 0.4 V or 0.2 V *vs.* SSCE.

### step 4: Overoxidation of the PEDOT/PBPA layer

The overoxidation of the PEDOT layer, prepared in step 2, was carried out in a three-electrode cell, its volume was 150 cm³, and the working electrode is a PBPA reinforced PEDOT layer deposited on a gold disk (*A* = 0.196 cm²), the reference electrode was sodium chloride saturated calomel electrode (SSCE), the counter electrode was a ring-shaped platinum plate. These electrodes were immersed in a 0.1 mol / dm³ H₂S0₄ solution. During overoxidation, the potential window was *E* = 0.4 - 1.5 V *vs.* SSCE, scanning speed was *v* = 50 mV/s, and the number of cycles was 3.

### step 5: Investigation of the overoxidized PEDOT layer

The electrochemical investigation of the overoxidized PEDOT layer, prepared in step 4, was carried out in a three-electrode cell, its volume was 150 cm³, in which the working electrode is a PBPA-reinforced PEDOT layer deposited on a gold disk (*A* = 0.196 cm²), the reference electrode was sodium chloride saturated calomel electrode (SSCE), and the counter electrode was a ring-shaped platinum plate. These electrodes were immersed in a 0.1 mol / dm³ H₂S0₄ solution. The potential window during the cyclic voltammetric investigations was *E* = (-0.1)-(+0.8) V *vs.* SSCE, scanning speed was *v* = 100 and 50 mV/s. Electrochemical impedance spectroscopic (EIS) measurements were performed in the frequency range of 50 kHz-96.1 mHz, the perturbation signal amplitude was 5 mV, and the electrode potential was *E* = 0.4 V or 0.2 V *vs.* SSCE.

The content of **Figure 3** discussed in more detail: Studies have shown that the PBPA-supported / reinforced PEDOT layer is more resistant to overoxidation than the pure PEDOT film. Unlike the PEDOT film (Fig. 3a), the PEDOT/PBPA layer **(****Fig 3b****)** did not delaminate from the substrate caused by overoxidation.

### Example 10:

Deposition of the Bisphenol A layer after the ferrate treatment
(1) Electrochemical deposition of PEDOT layer on gold substrate, under galvanostatic conditions (*j* = 0.2 mA/cm², *t* = 3600 s) from 0.01 M EDOT/0.1 M Na₂SO₄ electrolyte (pH = 5, counter electrode: Pt, reference electrode: SCE).
(2) The immersion of PEDOT layer into 0.05 M K₂FeO₄/KOH solution, and its potentiodynamic cyclization: 21 cycles, (pH = 14-10*, *E* = -0.4-(+0.3) V vs. SCE; *v* = 100mV/s.)
   *: The pH is decreasing during the process.
(3) Deposition of poly(bisphenol A) layer from 100 ppm BPA / 0.1 M Na₂SO₄ (pH = 5) electrolyte solution in a potentiodynamic way (10 cycles, *E* = -0.2-(+0.8) V vs. SSCE; *v* = 100 mV/s).

Fe content of the material formed: 13.3 % (atom%).

### Example 11:

Deposition of the Bisphenol A layer before the ferrate treatment
(1) Electrochemical deposition of PEDOT layer on gold substrate, under galvanostatic conditions (*j* = 0.2 mA/cm², *t* = 3600 s) from 0.01 M EDOT/0.1 M Na₂SO₄ electrolyte (counter electrode: Pt, reference electrode: SCE).
(2) Deposition of poly(bisphenol A) layer from 100 ppm BPA / 0.5 M H₂SO₄ (pH = 0.6) electrolyte solution in a potentiodynamic way (10 cycles, *E* = -0.1-(+1.0) V vs. SSCE; *v* = 100 mV/s).
(3) The reduction of the deposited PEDOT/PBPA layer was carried out in a 0.1 M Na₂SO₄ (pH = 5) solution (*E* = -0.3 V, *t* = 120 s). A sodium chloride saturated calomel electrode (SSCE) was used as a reference electrode.
(4) The reduced PEDOT layer was immersed in a 0.05 M K₂FeO₄/KOH solution (*t* = 30 s; pH = 14-10*).
(5) Steps (2) and (3) were performed 10 times consecutively.
   *: The pH is decreasing during the process.

Fe content of the material: 0.5 atom%.

### III. Synthesis of PANI film-containing composites

Instead of applying galvanostatic polymerization - as in the synthesis of PEDOT films - in case of certain polymers, e.g., polyaniline, potentiodynamic deposition is recommended, as galvanostatic deposition is less efficient. Further steps of preparation are the same as those discussed for PEDOT.

### Example 12:

(1) Electrochemical deposition of PANI film on gold substrate in a potentiodynamic way (*E* = 0.2-0.8 V, *v* = 100 mV/s, 40 cycles) from 0.2 M anilin / 0.5 M H₂SO₄ electrolyte (counter electrode: Pt, reference electrode: SCE).
(2) The deposited PANI layer was reduced in a 0.1 M Na₂SO₄ (pH = 5) solution (*E* = -1.3 V *vs.* SSCE; *t* = 300 s).
(3) The reduced PEDOT layer was immersed in a 0.05 M Na₂FeO₄/ NaOH solution (pH = 14-*10*, t =* 300 s).
*: The pH is decreasing during the process.

The incorporation of iron into the polymer film is observable as the initially bright green polymer layer turns into purple-bluish after the treatment.

## Claims

1. A process for the electrochemical production of an iron oxide/hydroxide-containing conducting polymer composite by one of the following processes:
Process I, which comprises the following steps:
a) providing a conducting polymer layer, optionally performing partial irreversible electrochemical oxidation (overoxidation) on the conducting polymer layer;
b) electrochemical reduction of the conducting polymer layer, optionally in a solution containing ferrate ions;
c) contacting the reduced conducting polymer layer with an aqueous solution of ferrate ions;
d) optionally repeating steps b) and c);
e) optionally separating the composite from the electrode used in the electrochemical reactions, and, if desired, drying the composite; or
Process II, which comprises the following steps:
a) providing a conducting polymer layer, optionally electrochemically reducing the conducting polymer layer;
b) contacting the conducting polymer layer with an aqueous solution of ferrate ions;
c) electrochemical oxidation of the conducting polymer layer in an aqueous solution of ferrate ions;
d) electrochemical reduction of the oxidized conducting polymer layer in an aqueous solution of ferrate ions;
e) optionally repeating steps c) and d);
f) optionally separating the composite from the electrode used in the electrochemical reactions, and, if desired, drying the composite.

2. The process according to claim 1, wherein in steps I a) and II a), the conducting polymer layer is produced in an electrochemical way, in which the conducting polymer layer is deposited on a substrate by galvanostatic or potentiodynamic way.

3. The process according to claim 2, wherein the substrate is selected from: gold, platinum, graphite, glassy carbon, conducting carbon layers and carbon fibers; preferably gold.

4. The process according to any one of claims 1 to 3, wherein steps I b) and I c) or steps II c) and II d) are repeated 5 to 20 times, preferably 8 to 12 times in step I d), or in step II e).

5. The process according to any one of claims 1 to 4, wherein the reduction according to step I b) is performed in a solution that is containing ferrate ions, and the contacting according to step I c) is performed in a way that the conducting polymer layer is allowed to stand in the ferrate solution of step I b), and optionally additional ferrate salt, preferably Na or K salt, is added to the solution.

6. The process according to any one of claims 1 to 5, wherein in step II e), steps c) and d) are repeated by cyclic voltammetry (i.e., potentiodynamic cyclization).

7. An iron oxide/hydroxide-containing conducting polymer composite, which is obtainable by the processes according to any of claims 1 to 6.

8. The iron oxide/hydroxide-containing conducting polymer composite according to claim 7, wherein the conducting polymer is reinforced with a polymer deposited on it, preferably the deposited polymer is poly(bisphenol A) [PBPA].

9. An iron oxide/hydroxide-containing conducting polymer composite, which comprises
a) a conducting polymer, and
b) an iron oxide/hydroxide compound incorporated in the conducting polymer,
wherein the iron oxide/hydroxide compound is other than magnetite (Fe₃O₄), and
wherein the conducting polymer is different from polyaniline (PANI), and
wherein the conducting polymer is reinforced with a polymer deposited on it.

10. The iron oxide/hydroxide-containing conducting polymer composite according to claim 9, wherein the polymer deposited on conducting polymer is electrodeposited poly(bisphenol A) [PBPA].

11. The iron oxide/hydroxide-containing conducting polymer composite according to claim 9 or 10, wherein the conducting polymer is selected from poly(3,4-ethylenedioxythiophene) i.e., PEDOT and poly(orthophenylenediamine) i.e., PoPD, preferably PEDOT.

12. The iron oxide/hydroxide-containing conducting polymer composite according to any of claims 9 or 11, wherein the iron oxide/hydroxide compound is selected from: Fe₂O₃, Fe(OH)₂, Fe(OH)₃, and FeO(OH).

13. The iron oxide/hydroxide-containing conducting polymer composite according to any one of claims from 9 to 12, wherein the amount of iron oxide/hydroxide compound other than magnetite is at least 1 to 25 wt%, preferably it is 2 to 10 wt% in the composite, calculated from the total mass of the iron oxide/hydroxide compounds.

## Patentansprüche

1. Verfahren zur elektrochemischen Herstellung eines Eisenoxid/-hydroxid enthaltenden leitfähigen Polymerverbundwerkstoffs nach einem der folgenden Verfahren:
Verfahren I, das die folgenden Schritte umfasst:
a) Bereitstellen einer Schicht aus leitfähigem Polymer, wobei gegebenenfalls eine partielle irreversible elektrochemische Oxidation (Überoxidation) auf der Schicht aus leitfähigem Polymer durchgeführt wird;
b) elektrochemische Reduktion der Schicht aus leitfähigem Polymer, gegebenenfalls in einer Ferrationen enthaltenden Lösung;
c) Inkontaktbringen der Schicht aus reduziertem leitfähigem Polymer mit einer wässrigen Lösung von Ferrationen;
d) gegebenenfalls Wiederholen der Schritte b) und c);
e) gegebenenfalls Abtrennen des Verbundwerkstoffs von der bei den elektrochemischen Reaktionen verwendeten Elektrode und gewünschtenfalls Trocknen des Verbundwerkstoffs; oder
Verfahren II, das die folgenden Schritte umfasst:
a) Bereitstellen einer Schicht aus leitfähigem Polymer, wobei die Schicht aus leitfähigem Polymer gegebenenfalls elektrochemisch reduziert wird;
b) Inkontaktbringen der Schicht aus leitfähigem Polymer mit einer wässrigen Lösung von Ferrationen;
c) elektrochemische Oxidation der Schicht aus leitfähigem Polymer in einer wässrigen Lösung von Ferrationen;
d) elektrochemische Reduktion der Schicht aus oxidiertem leitfähigem Polymer in einer wässrigen Lösung von Ferrationen;
e) gegebenenfalls Wiederholen der Schritte c) und d);
f) gegebenenfalls Abtrennen des Verbundwerkstoffs von der bei den elektrochemischen Reaktionen verwendeten Elektrode und gewünschtenfalls Trocknen des Verbundwerkstoffs.

2. Verfahren nach Anspruch 1, wobei in den Schritten I a) und II a) die Schicht aus leitfähigem Polymer elektrochemisch hergestellt wird, wobei die Schicht aus leitfähigem Polymer galvanostatisch oder potentiodynamisch auf einem Substrat abgeschieden wird.

3. Verfahren nach Anspruch 2, wobei das Substrat aus Gold, Platin, Graphit, Glaskohlenstoff, Schichten aus leitfähigem Kohlenstoff und Kohlenstofffasern, vorzugsweise Gold, ausgewählt wird.

4. Verfahren nach einem der Ansprüche 1 bis 3, wobei die Schritte I b) und I c) bzw. die Schritte II c) und II d) in Schritt I d) bzw. in Schritt II e) 5- bis 20-mal, vorzugsweise 8- bis 12-mal, wiederholt werden.

5. Verfahren nach einem der Ansprüche 1 bis 4, wobei die Reduktion gemäß Schritt I b) in einer Ferrationen enthaltenden Lösung durchgeführt wird und das Inkontaktbringen gemäß Schritt I c) so durchgeführt wird, dass die Schicht aus leitfähigem Polymer in der Ferratlösung von Schritt I b) stehen gelassen wird und gegebenenfalls zusätzliches Ferratsalz, vorzugsweise Na- oder K-Salz, zu der Lösung gegeben wird.

6. Verfahren nach einem der Ansprüche 1 bis 5, wobei in Schritt II e) die Schritte c) und d) durch zyklische Voltammetrie (d. h. potentiodynamische Zyklisierung) wiederholt werden.

7. Eisenoxid/-hydroxid enthaltender leitfähiger Polymerverbundwerkstoff, der nach den Verfahren nach einem der Ansprüche 1 bis 6 erhältlich ist.

8. Eisenoxid/-hydroxid enthaltender leitfähiger Polymerverbundwerkstoff nach Anspruch 7, wobei das leitfähige Polymer mit einem darauf abgeschiedenen Polymer verstärkt ist und es sich bei dem abgeschiedenen Polymer vorzugsweise um Poly(bisphenol-A) [PBPA] handelt.

9. Eisenoxid/-hydroxid enthaltender leitfähiger Polymerverbundwerkstoff, der Folgendes umfasst:
a) ein leitfähiges Polymer und
b) eine Eisenoxid/-hydroxid-Verbindung, die in das leitfähige Polymer eingearbeitet ist,
wobei die Eisenoxid/-hydroxid-Verbindung von Magnetit (Fe₃O₄) verschieden ist und
wobei das leitfähige Polymer von Polyanilin (PANI) verschieden ist und
wobei das leitfähige Polymer mit einem darauf abgeschiedenen Polymer verstärkt ist.

10. Eisenoxid/-hydroxid enthaltender leitfähiger Polymerverbundwerkstoff nach Anspruch 9, wobei es sich bei dem auf dem leitfähigen Polymer abgeschiedenen Polymer um galvanisch abgeschiedenes Poly(bisphenol-A) [PBPA] handelt.

11. Eisenoxid/-hydroxid enthaltender leitender Polymerverbundwerkstoff nach Anspruch 9 oder 10, wobei das leitfähige Polymer aus Poly(3,4-ethylendioxythiophen), d. h. PEDOT, und Poly(orthophenylendiamin), d. h. PoPD, vorzugsweise PEDOT, ausgewählt ist.

12. Eisenoxid/-hydroxid enthaltender leitfähiger Polymerverbundwerkstoff nach einem der Ansprüche 9 oder 11, wobei die Eisenoxid/-hydroxid-Verbindung ausgewählt ist aus: Fe₂O₃, Fe(OH)₂, Fe(OH)₃ und FeO(OH).

13. Eisenoxid/-hydroxid enthaltender leitfähiger Polymerverbundwerkstoff nach einem der Ansprüche 9 bis 12, wobei die Menge an Eisenoxid/-hydroxid-Verbindung mit Ausnahme von Magnetit in dem Verbundwerkstoff mindestens 1 bis 25 Gew.-%, vorzugsweise 2 bis 10 Gew.-%, bezogen auf die Gesamtmasse der Eisenoxid/-hydroxid-Verbindungen, beträgt.

## Revendications

1. Procédé de production électrochimique d'un composite de polymère conducteur contenant de l'oxyde/hydroxyde par l'un des procédés suivants :
Procédé I, qui comprend les étapes suivantes :
a) fourniture d'une couche de polymère conducteur, éventuellement réalisation d'une oxydation électrochimique irréversible partielle (suroxydation) sur la couche de polymère conducteur ;
b) réduction électrochimique de la couche de polymère conducteur, éventuellement dans une solution contenant des ions ferrate ;
c) mise en contact de la couche de polymère conducteur réduite avec une solution aqueuse d'ions ferrate ;
d) éventuellement répétition des étapes b) et c) ;
e) éventuellement séparation du composite de l'électrode utilisée dans les réactions électrochimiques et, si cela est souhaité, séchage du composite ; ou
Procédé II, qui comprend les étapes suivantes :
a) fourniture d'une couche de polymère conducteur, éventuellement réduction de manière électrochimique de la couche de polymère conducteur ;
b) mise en contact de la couche de polymère conducteur avec une solution aqueuse d'ions ferrate ;
c) oxydation électrochimique de la couche de polymère conducteur dans une solution aqueuse d'ions ferrate ;
d) réduction électrochimique de la couche de polymère conducteur oxydée dans une solution aqueuse d'ions ferrate ;
e) éventuellement répétition des étapes c) et d) ;
f) éventuellement séparation du composite de l'électrode utilisée dans les réactions électrochimiques et, si cela est souhaité, séchage du composite.

2. Procédé selon la revendication 1, dans lequel dans les étapes I a) et II a), la couche de polymère conducteur est produite d'une manière électrochimique, dans lequel la couche de polymère conducteur est déposée sur un substrat par voie galvanostatique ou potentiodynamique.

3. Procédé selon la revendication 2, dans lequel le substrat est choisi parmi : l'or, le platine, le graphite, le carbone vitreux, les couches de carbone conducteur et les fibres de carbone ; de préférence l'or.

4. Procédé selon l'une quelconque des revendications 1 à 3, dans lequel les étapes I b) et I c) ou les étapes II c) et II d) sont répétées 5 à 20 fois, de préférence 8 à 12 fois dans l'étape I d) ou dans l'étape II e).

5. Procédé selon l'une quelconque des revendications 1 à 4, dans lequel la réduction selon l'étape I b) est effectuée dans une solution qui contient des ions ferrate, et la mise en contact selon l'étape I c) est effectuée de manière à laisser reposer la couche de polymère conducteur dans la solution ferrate de l'étape I b), et éventuellement un sel de ferrate supplémentaire, de préférence un sel de Na ou K, est ajouté à la solution.

6. Procédé selon l'une quelconque des revendications 1 à 5, dans lequel dans l'étape II e), les étapes c) et d) sont répétées par voltamétrie cyclique (c'est-à-dire cyclisation potentiodynamique).

7. Composite de polymère conducteur contenant de l'oxyde/hydroxyde de fer, qui peut être obtenu par les procédés selon l'une quelconque des revendications 1 à 6.

8. Composite de polymère conducteur contenant un oxyde/hydroxyde de fer selon la revendication 7, dans lequel le polymère conducteur est renforcé par un polymère déposé sur lui, de préférence le polymère déposé est un poly(bisphénol A) [PBPA].

9. Composite de polymère conducteur contenant de l'oxyde/hydroxyde de fer, qui comprend
a) un polymère conducteur, et
b) un composé d'oxyde/hydroxyde de fer incorporé dans le polymère conducteur,
dans lequel le composé d'oxyde/hydroxyde de fer est autre que la magnétite (Fe₃O₄), et
dans lequel le polymère conducteur est différent de la polyaniline (PANI), et
dans lequel le polymère conducteur est renforcé par un polymère déposé sur lui.

10. Composite de polymère conducteur contenant un oxyde/hydroxyde de fer selon la revendication 9, dans lequel le polymère déposé sur le polymère conducteur est un poly(bisphénol A) [PBPA] déposé par électrodéposition.

11. Composite de polymère conducteur contenant un oxyde/hydroxyde de fer selon la revendication 9 ou 10, dans lequel le polymère conducteur est choisi parmi un poly(3,4-éthylènedioxythiophène), c'est-à-dire, un PEDOT, et une poly(orthophénylènediamine), c'est-à-dire une PoPD, de préférence un PEDOT.

12. Composite de polymère conducteur contenant un oxyde/hydroxyde de fer selon l'une quelconque des revendications 9 ou 11, dans lequel le composé d'oxyde/hydroxyde de fer est choisi parmi : Fe₂O₃, Fe(OH)₂, Fe(OH)₃ et FeO(OH).

13. Composite de polymère conducteur contenant un oxyde/hydroxyde de fer selon l'une quelconque des revendications 9 à 12, dans lequel la quantité de composé d'oxyde/hydroxyde de fer autre que la magnétite est d'au moins 1 à 25 % en poids, de préférence de 2 à 10 % en poids dans le composite, calculée à partir de la masse totale des composés d'oxyde/hydroxyde de fer.
